# EUROPEAN PATENT APPLICATION

(11) **EP 4 788 086 A1**
(43) Date of publication of application: **05.08.2026**
(21) Application number: 25174699.6
(22) Date of filing: 07.05.2025
(51) Int. Cl.: H10D 10/01, H10D 10/80, H10D 62/10, H10D 62/13, H10D 62/17, H10D 62/40

(54) **LATERAL BIPOLAR TRANSISTORS HAVING COLLECTOR AND EMITTER OVER THE BASE**

(30) Priority: 03.02.2025 US 202519044120
(71) Applicant: GlobalFoundries U.S. Inc., Malta, NY 12020 (US)
(72) Inventor: RAGHUNATHAN, Uppili Srinivasan, Essex Junction, VT, 05452 (US); JAIN, Vibhor, Essex Junction, VT, 05452 (US); DERRICKSON, Alexander Montgomery, Malta, NY, 12020 (US); PEKARIK, John J., Essex Junction, VT, 05452 (US)
(74) Representative: Lambacher, Michael

(57) **Abstract**

The present disclosure relates to semiconductor structures and, more particularly, to a lateral heterojunction bipolar transistor (HBT) and methods of manufacture. The structure includes: a buried extrinsic base (20) within a semiconductor material (18); an intrinsic base (24) over and in electrical contact with the extrinsic base (20); an emitter (12) having a semiconductor material with a single crystalline orientation, the emitter being (12) above the intrinsic base (24) and comprising a faceted sidewall (12a); a collector (16) having the semiconductor material with the single crystalline orientation, the collector (16) being above the intrinsic base (24) and comprising a faceted sidewall (16a); and a spacer (14) between the emitter and the collector.

## Description

### BACKGROUND

The present disclosure relates to semiconductor structures and, more particularly, to lateral transistors and methods of manufacture.

A heterojunction bipolar transistor (HBT) is a type of bipolar junction transistor (BJT) which uses differing semiconductor materials for the emitter and base regions or collector and base regions, creating a heterojunction. HBTs are used in power amplifier and cellular applications, amongst others, and require low collector-base capacitance (Ccb), low base resistance (Rb), high cut-off frequencies (fT/fmax) and high breakdown voltage (BVceo). Current integration schemes for fabricating the HBT result in high Ccb (parasitic capacitance) and high Rb, which is a concern in bipolar technologies as it limits device scaling for improved fT/fmax.

### SUMMARY

In an aspect of the disclosure, a structure comprises: an extrinsic base within a semiconductor material; an emitter having a semiconductor material with a single crystalline orientation, the emitter being above the extrinsic base and comprising a faceted sidewall; a collector having the semiconductor material with the single crystalline orientation, the collector being above the extrinsic base and comprising a faceted sidewall; and a spacer between the emitter and the collector.
The collector and the emitter may be laterally separated by the spacer.
Further, the spacer may be a dielectric plug filling an opening between the emitter and the collector. The dielectric plug may completely fill the opening between the emitter and the collector. Alternatively, the dielectric plug may partially fill the opening between the emitter and the collector. Further, the structure may comprise a polysilicon material over the dielectric plug.
The faceted sidewall of the collector may be at a junction between the dielectric plug and the collector; further, the faceted sidewall of the emitter may be at a junction between the dielectric plug and the emitter. Further, the faceted sidewalls of the emitter and the collector may be provided along a crystallographic orientation of the semiconductor material.
In addition to the above-mentioned features, the structure may further comprise a base contact region adjacent to the spacer and above the extrinsic base, and a base contact electrically connecting to the base contact region. The base contact may be provided in a same active region as the emitter and the collector. Optionally, the base contact may be orthogonal to the emitter and the collector.

In an aspect of the disclosure, a structure comprises: an extrinsic base; an emitter above the extrinsic base; a collector above the extrinsic base; a spacer between the emitter and the collector; and faceted sidewalls at a junction at the spacer and the collector and at the spacer and the emitter.
The faceted sidewalls may be provided along a crystallographic orientation of semiconductor material of the emitter and the collector.
Further, the emitter and the collector may comprise epitaxially grown semiconductor material above the extrinsic base. For instance, the emitter and the collector of the structure may comprise SiGe.
Further, the spacer of the structure may be a dielectric plug completely filling an opening between the collector and the emitter. Further, the spacer may comprise dielectric material on sidewalls of the emitter and the collector and polysilicon material over the dielectric material.
Further, the structure may additionally comprise a base contact landing on the extrinsic base comprising polysilicon material. The base contact may be in a same active region of the collector and the emitter and may be orthogonally positioned with respect to the collector and the emitter.

In an aspect of the disclosure, a method comprises: forming an extrinsic base within a semiconductor material; forming an emitter having a semiconductor material with a single crystalline orientation, the emitter being above the extrinsic base and comprising a faceted sidewall; forming a collector having the semiconductor material with the single crystalline orientation, the collector being above the extrinsic base and comprising a faceted sidewall; and forming a spacer between the emitter and the collector.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a top view of a structure and respective fabrication processes in accordance with aspects of the present disclosure.
FIG. 1B shows a cross-sectional view of the structure of FIG. 1A along an X-X axis in accordance with aspects of the present disclosure.
FIG. 1C shows a cross-sectional view of the structure of FIG. 1A along a Y-Y axis in accordance with aspects of the present disclosure.
FIG. 2A shows a top view of a structure and respective fabrication processes in accordance with additional aspects of the present disclosure.
FIG. 2B shows a cross-sectional view of the structure of FIG. 2A along an X-X axis in accordance with aspects of the present disclosure.
FIG. 3 shows a cross-sectional view of a structure and respective fabrication processes in accordance with additional aspects of the present disclosure.
FIG. 4 shows a flow diagram of processes of fabricating faceted sidewalls of an emitter and collector in accordance with aspects of the present disclosure.

### DETAILED DESCRIPTION

The present disclosure relates to semiconductor structures and, more particularly, to lateral transistors and methods of manufacture. More specifically, the lateral transistors may be lateral heterojunction bipolar transistors comprising an emitter/collector with faceted sidewalls and a dielectric plug adjacent to the faceted sidewalls. In embodiments, the dielectric plug may be between the emitter and collector. Advantageously, the heterojunction bipolar transistor provides improved performance, e.g., higher fmax, with a reduced lateral area and the ability to use SiGe epitaxial and polysilicon layers (e.g., emitter and base) from existing fabrication processes for vertical devices. The reduction in area, e.g., minimizing a footprint, provides significant value to high speed digital applications relating to memory I/O, computing, and other mixed signal applications.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

It should be recognized by one of ordinary skill in the art that the devices described herein may either be a p-type bipolar transistor or an n-type bipolar transistor. Also, it should be recognized by one of ordinary skill in the art, similar to the NPN transistor presented in the embodiments described herein, the present disclosure may also be directed to a PNP transistor by inverting the doping region-by-region from P-type to N-type and vice versa.

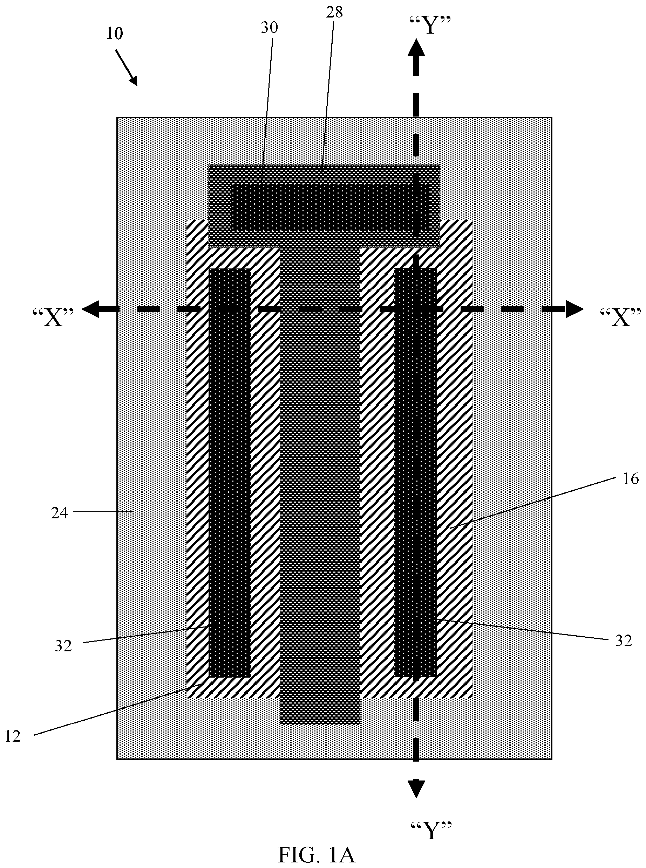

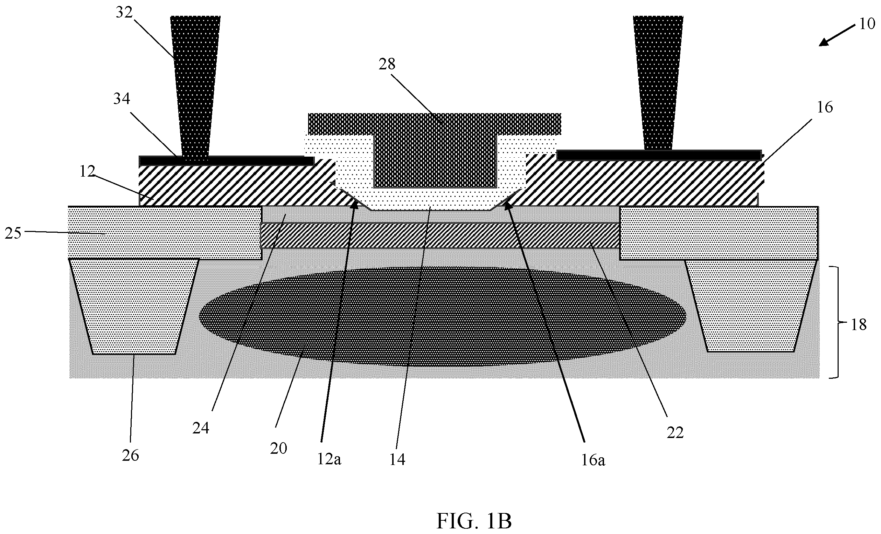

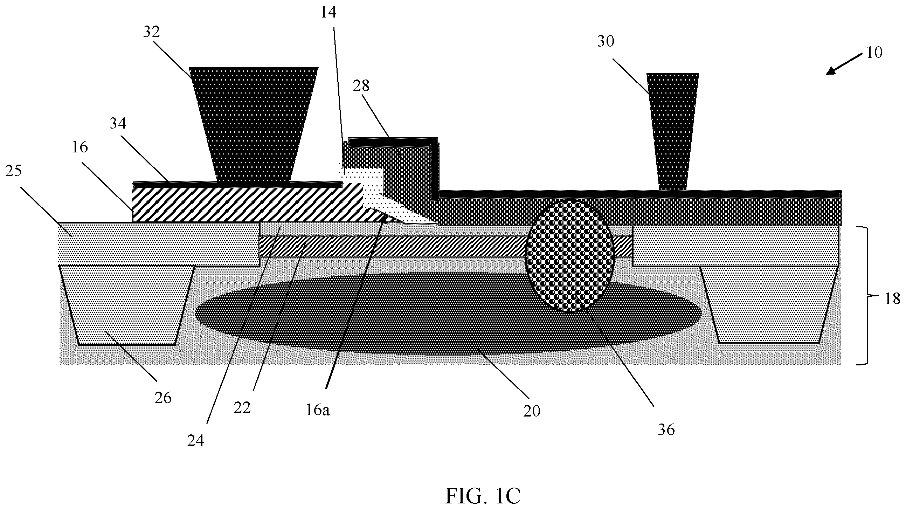

FIG. 1A shows a top view of a structure and respective fabrication processes in accordance with aspects of the present disclosure. FIG. 1B shows a cross-sectional view of the structure of FIG. 1A along an X-X axis and FIG. 1C shows a cross-sectional view of the structure of FIG. 1A along a Y-Y axis. Referring to FIGS. 1A-1C, the structure 10 includes an emitter 12 with a faceted sidewall 12a at a junction between the emitter 12 and a dielectric plug (e.g., spacer) 14. Similarly, the structure 10 includes a collector 16 with a faceted sidewall 16a between the dielectric plug (e.g., spacer) 14 and the collector 16. In embodiments, the semiconductor material of the emitter 12 and the collector 16 may be the same semiconductor material formed in the same fabrication processes. For example, the emitter 12 and the collector 16 may be, e.g., epitaxially grown SiGe material. Also, the faceted sidewalls 12a, 16a may be formed along the crystallographic orientation of the semiconductor material when using an HCl etchant process. In further embodiments, the dielectric plug 16 may be a spacer of any insulator material, e.g., nitride and/or oxide, with a minimum etch critical dimension and which isolates the emitter 12 and the collector 16.

More specifically, the structure 10 may include a semiconductor substrate 18. The semiconductor substrate 18 may be composed of any suitable material including, but not limited to, Si, SiGe, SiGeC, SiC, GaAs, InAs, InP, and other III/V or II/VI compound semiconductors. The semiconductor substrate 18 may be a single crystalline semiconductor material that comprises any suitable crystallographic orientation (e.g., a (100), (110), (111), or (001) crystallographic orientation). In embodiments, the semiconductor substrate 18 may be a p-type substrate. The semiconductor substrate 18 may be bulk substrate as is known in the art such that no further explanation is required for a complete understanding of the present disclosure.

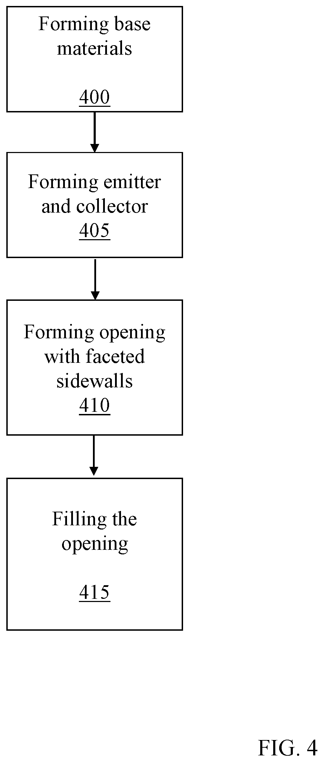

The semiconductor substrate 18 may include an extrinsic base 20. In embodiments, the extrinsic base 20 may be a heavily doped P-type well formed by a conventional ion implantation process. For example, the extrinsic base 20 may be formed by introducing a P-type dopant by ion implantation process in the semiconductor substrate 18 as described with respect to FIG. 4.

Still referring to FIGS. 1A-1C, the structure 10 further includes a doped semiconductor material 22 and an intrinsic semiconductor material 24 above the extrinsic base 20. In embodiments, the combination of the semiconductor material 22 and the intrinsic semiconductor material 24 may act as an intrinsic base. The semiconductor material 22 may be a layer of SiGe epitaxially grown on the semiconductor substrate 18 and the semiconductor layer 24 may be epitaxially grown on the semiconductor material 22 as further described with respect to FIG. 4.

In embodiments, the semiconductor materials 22, 24 may be vertically above the extrinsic base 20 and may further contact and be between insulator material 25. In embodiments, the insulator material 25 may be conduction band oxide. As should be understood by those of ordinary skill in the art, the conduction band oxide is a type of oxide material where the conduction band (e.g., the energy level where electrons can freely move) is readily accessible, allowing for good electrical conductivity. In this way, the oxide material may act as a semiconductor material with relatively good electron mobility within its conduction band. The insulator material 25 may be used for forming a selective intrinsic base epitaxy film.

Trench isolation structures 26 may be provided in the semiconductor substrate 18 below the insulator material 25. The trench isolation structures 26 may isolate the extrinsic base 20 from other structures. In embodiments, the trench isolation structures 26 may be shallow trench isolation structures or deep trench isolation structures.

The trench isolation structures 26 may be formed by conventional lithography, etching and deposition methods known to those of skill in the art. For example, a resist formed over the semiconductor substrate 18 is exposed to energy (light) and developed utilizing a conventional resist developer to form a pattern (opening). An etching process with a selective chemistry, e.g., reactive ion etching (RIE), may be used to transfer the pattern from the patterned photoresist layer to the semiconductor substrate 18 to form one or more trenches in the semiconductor substrate 18 through the openings of the resist. Following the resist removal by a conventional oxygen ashing process or other known stripants, the insulator material (e.g., oxide based material) can be deposited by any conventional deposition processes, e.g., chemical vapor deposition (CVD) processes. Any residual material on the surface of the semiconductor substrate 18 can be removed by conventional chemical mechanical polishing (CMP) processes.

The emitter 12 and the collector 16 may be formed above the semiconductor material 22 and, more specifically, above the extrinsic base 20 and the intrinsic base between the insulator material 25. In embodiments, the emitter 12 and the collector 16 will overlap the intrinsic base region and, more specifically, the semiconductor material 22, e.g., layer of epitaxially grown SiGe. The emitter 12 and the collector 16 may comprise a same semiconductor material and have a co-planar surface. The semiconductor material of the emitter 12 and the collector 16 may be SiGe, with a gradient of Ge to Si, or may be composed of other semiconductor materials with a single crystalline orientation as is known in the art such that no further explanation is required for a complete understanding of the present disclosure. Also, the emitter 12 and the collector 16 may be laterally separated by the dielectric plug 14.

Advantageously, the emitter 12 and the collector 16 may be of the same semiconductor material and, hence, formed in the same semiconductor fabrication processes. For example, the emitter 12 and the collector 16 may be formed in the same epitaxial growth process over and in contact with the semiconductor material 22. In embodiments, the emitter 12 and the collector 16 may epitaxially grown SiGe material with a single crystalline orientation.

The dielectric plug (e.g., spacer) 14 may be formed between the emitter 12 and the collector 16. In embodiments, the dielectric plug 14 may be formed by etching of the semiconductor material of the emitter 12 and the collector 16, followed by a deposition of insulator material. The etching process, e.g., HCl etching process, will etch along the crystalline orientation of the semiconductor material resulting in the faceted sidewalls 12a, 16a of the emitter 12 and the collector 16, respectively. In any of the embodiments described herein, the faceted sidewalls 12a, 16a may partially or fully extend the thickness of the emitter 12 and the collector 16 depending on the etching process and design parameters.

As further shown in FIGS. 1B and 1C, the opening or space formed by the etching process will be partially filled with dielectric material, e.g., oxide or nitride, by a conventional deposition process, e.g., chemical vapor deposition. For example, the dielectric material, e.g., oxide or nitride, may be used to line the faceted sidewalls or provide a more complete fill of the space, depending on the design parameters. In any configuration, though, the deposition process will result in the faceted sidewalls 12a, 16a at a junction of the dielectric plug 14 and the respective emitter 12 and collector 16.

A semiconductor material 28 may be formed over the dielectric plug 14 to further fill the space between the emitter 12 and collector 16. In embodiments, the semiconductor material 28 may be polysilicon material that comprises a planar surface above a top surface of the semiconductor material of the emitter 12 and collector 16. In further embodiments, a base contact 30 may contact the semiconductor material 28 as shown in FIGS. 1A and 1C. In embodiments, the base contact 30 may be orthogonal to the emitter 12 and the collector 16.

The dielectric material of the dielectric plug 14 and the semiconductor material 28 may be patterned to expose the underlying semiconductor material of the emitter 12 and the collector 16. The dielectric material of the dielectric plug 14 and the semiconductor material 28 may be patterned by conventional lithography and etching processes as described herein such that no further explanation is required for a complete understanding of the present disclosure. Contacts 32 may be formed on the exposed semiconductor material of the emitter 12 and the collector 16.

Prior to forming the contacts 30, 32, a silicide contact 34 may be formed on the exposed semiconductor surfaces of the emitter 12, the collector 16 and semiconductor material 28, e.g., base semiconductor material. As should be understood by those of skill in the art, the silicide process begins with deposition of a thin transition metal layer, e.g., nickel, cobalt or titanium, over exposed semiconductor material. After deposition of the material, the structure is heated allowing the transition metal to react with exposed silicon (or other semiconductor material as described herein) in the active regions of the semiconductor device (e.g., the emitter 12, the collector 16 and semiconductor material 28, e.g., base semiconductor material) forming a low-resistance transition metal silicide. Following the reaction, any remaining transition metal is removed by chemical etching, leaving silicide contacts in the active regions of the device.

Referring to FIG. 1C, the base contact 30 may be provided on the semiconductor material 28. A base contact implant region 36 may extend within the semiconductor material 28 and to the extrinsic base 20. In more specific embodiments, the base contact implant region 36 may be in the same active region as the intrinsic base, e.g., SiGe material 22, the extrinsic base 20 and the semiconductor material 28, e.g., polysilicon material. The base contact implant region 36 may be a P-type implant, e.g., Boron, which is fabricated using conventional ion implantation processes as described herein. In embodiments, the base contact implant region 36 will provide electrical connection between the contact 30 and the extrinsic base 20. In further embodiments, the region 28 may serve as a second extrinsic base above the intrinsic base. The second extrinsic base may be connected to the first extrinsic base 20 through the base contact implant region (bridging implant) 36.

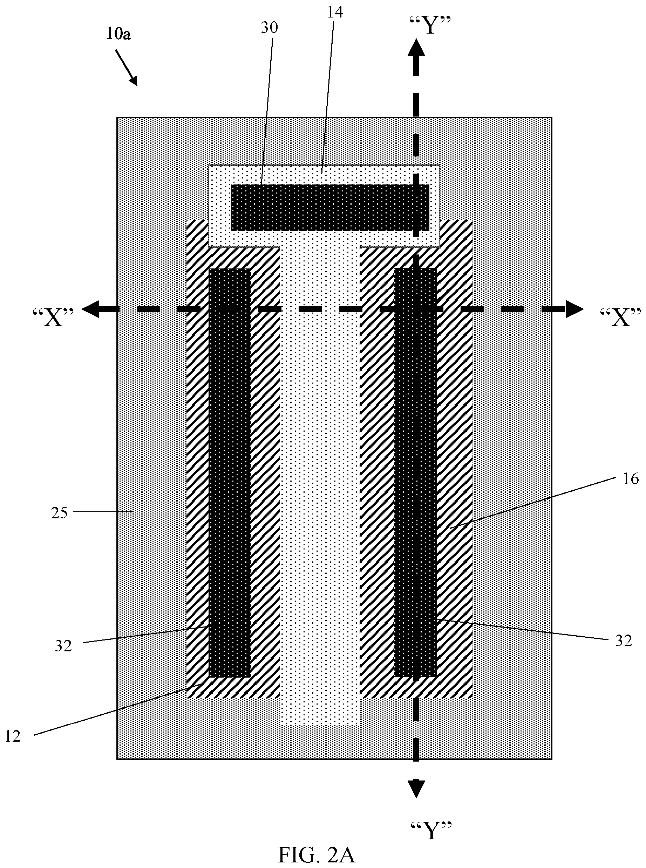

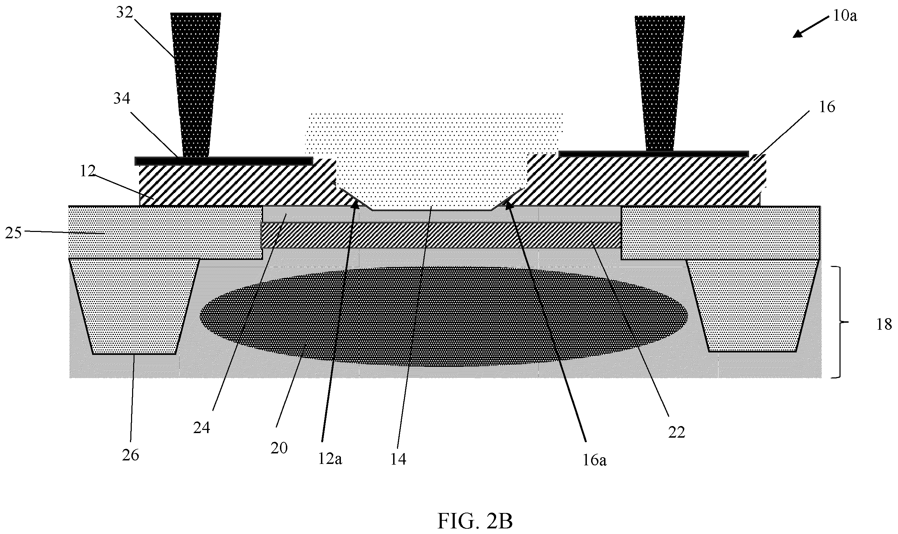

FIG. 2A shows a top view of a structure and respective fabrication processes in accordance with aspects of the present disclosure. FIG. 2B shows a cross-sectional view of the structure of FIG. 2A along an X-X axis. Referring to FIGS. 2A-2B, the structure 10a includes the emitter 12 with the faceted sidewall 12a at a junction between the emitter 12 and the dielectric plug 14. Similarly, the structure 10a includes the collector 16 with the faceted sidewall 16a between the dielectric plug 14 and the collector 16. In embodiments, the use of minimal dimension lithography may result in the plugged spacer formation. The polysilicon material 28 may be etched above the spacers (e.g., dielectric material 14), with the narrow emitter to collector separation preventing erosion of the spacers during the etch of the polysilicon material 28. In embodiments, the polysilicon material 28 may be retained for the base contact as shown in FIG. 1C. The remaining features of the structure 10a are similar to the structure 10 of FIGS. 1A-1C such that no further explanation is required for a complete understanding of the present disclosure.

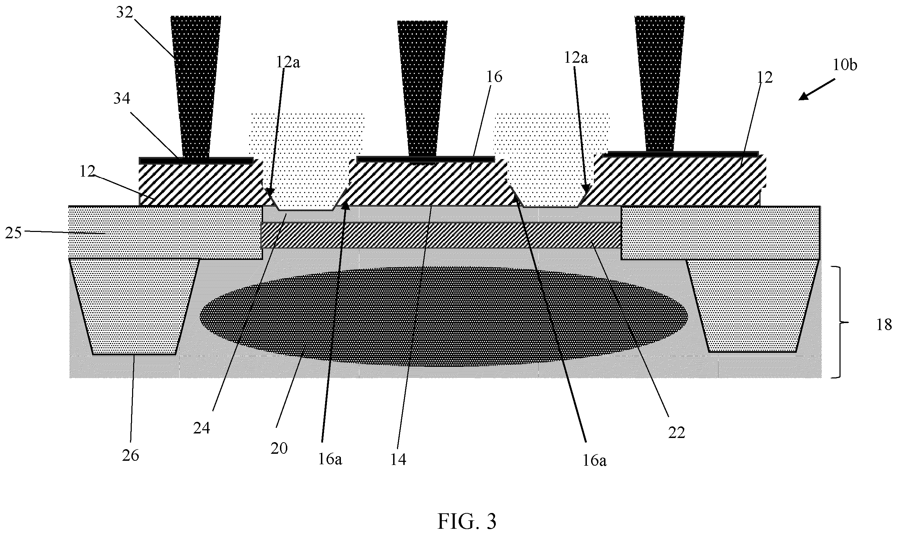

FIG. 3 shows a cross-sectional view of a structure in accordance with additional aspects of the present disclosure. The structure 10b of FIG. 3 shows a multi-emitter device on a single active area. In this structure 10b, a single collector 16 is surrounded by two emitters 12, separated by the two dielectric plugs 14. In this embodiment, the collector 16 includes two faceted sidewalls 16a at the junction of the dielectric plug 14; whereas each emitter 12 includes a single faceted sidewall 12a at the junction with the dielectric plug 14. Although this embodiment shows the dielectric plug fully filling the space between the emitters 12 and the collector 16, it is also contemplated that polysilicon material may be provided over the dielectric plug 14 to fill the space between the emitters 12 and the collector 16 as shown in FIG. 1B. The remaining features of the structure 10b are similar to the structure 10 of FIGS. 1A-1C or structure 10a of FIGS. 2A-2C such that no further explanation is required for a complete understanding of the present disclosure.

FIG. 4 shows a flow diagram of processes of fabricating the faceted sidewalls of the emitter and collector in accordance with aspects of the present disclosure. At step 400, the base materials are formed. For example, the extrinsic base 20 may be a heavily doped P-type well formed in the semiconductor substrate 18 by a conventional ion implantation process. In an ion implantation process, a patterned implantation mask may be used to define selected areas exposed for the implantations. The implantation mask may include a layer of a light-sensitive material, such as an organic photoresist, applied by a spin coating process, pre-baked, exposed to light projected through a photomask, baked after exposure, and developed with a chemical developer. The implantation mask has a thickness and stopping power sufficient to block masked areas against receiving a dose of the implanted ions. The extrinsic base 20 is doped with p-type dopants such as Boron. An annealing process may be performed to drive in the dopants into the semiconductor substrate 18.

The processes further include providing a doped semiconductor material 22 and an intrinsic semiconductor material 24 above the extrinsic base 20. As noted herein, the combination of the semiconductor material 22 and the intrinsic semiconductor material 24 may act as an intrinsic base. The semiconductor materials 22, 24 may be epitaxially grown semiconductor layers on the semiconductor substrate 18. By way of example, various epitaxial growth process apparatuses can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300 °C to 800 °C. The epitaxial growth can be performed utilizing any well-known precursor gas or gas mixture. Carrier gases like hydrogen, nitrogen, helium and argon can be used. A p-type dopant may be typically added to the precursor gas or gas mixture during the formation of the SiGe material, e.g., semiconductor material 22.

At step 405, the emitter 12 and the collector 16 may be formed above the extrinsic base 20 and the intrinsic base between the insulator material 25. The emitter 12 and the collector 16 may be formed by an epitaxial growth process with semiconductor materials comprising a single crystalline orientation.

At step 410, an opening is formed in the semiconductor material of the emitter 12 and the collector 16. In embodiments, the opening is formed by conventional lithography and etching processes. The etching process will follow the crystalline orientation (e.g., crystal grain) of the semiconductor material of the emitter 12 and the collector 16, resulting in a faceted sidewall 12s, 16a.

At step 415, the opening is filled with dielectric material 14. The dielectric material 14, e.g., oxide or nitride, by a conventional deposition process, e.g., chemical vapor deposition. This deposition process will result in faceted sidewalls 12a, 16a at a junction between the dielectric material 14 and the emitter 12 and collector 16, respectively.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
an extrinsic base within a semiconductor material;
an emitter comprising a semiconductor material with a single crystalline orientation, the emitter being above the extrinsic base and comprising a faceted sidewall;
a collector comprising the semiconductor material with the single crystalline orientation, the collector being above the extrinsic base and comprising a faceted sidewall; and
a spacer between the emitter and the collector.

2. The structure of claim 1, wherein the spacer is a dielectric plug filling an opening between the emitter and the collector.

3. The structure of claim 2, wherein the dielectric plug completely fills the opening between the emitter and the collector, or wherein the dielectric plug partially fills the opening between the emitter and the collector.

4. The structure of claim 2 or claim 3, further comprising polysilicon material over the dielectric plug.

5. The structure of one of claims 2 to 4, wherein:
the faceted sidewall of the collector is at a junction between the dielectric plug and the collector; and
the faceted sidewall of the emitter is at a junction between the dielectric plug and the emitter.

6. The structure of one of claims 1 to 5, wherein the collector and the emitter are laterally separated by the spacer.

7. The structure of one of claims 1 to 6, wherein the faceted sidewalls of the emitter and the collector are provided along a crystallographic orientation of the semiconductor material.

8. The structure of one of claims 1 to 7, further comprising a base contact region adjacent to the spacer and above the extrinsic base, and a base contact electrically connecting to the base contact region.

9. The structure of claim 8, wherein the base contact is provided in a same active region as the emitter and the collector, and/or wherein the base contact is orthogonal to the emitter and the collector.

10. A structure comprising:
an extrinsic base;
an emitter above the extrinsic base;
a collector above the extrinsic base;
a spacer between the emitter and the collector; and
faceted sidewalls at a junction at the spacer and the collector and at the spacer and the emitter.

11. The structure of claim 10, wherein the faceted sidewalls are provided along a crystallographic orientation of semiconductor material of the emitter and the collector.

12. The structure of claim 10 or claim 11, wherein the emitter and the collector comprise epitaxially grown semiconductor material above the extrinsic base, and, optionally, wherein the emitter and the collector comprise SiGe.

13. The structure of one of claims 10 to 12, wherein the spacer is a dielectric plug completely filling an opening between the collector and the emitter, and/or wherein the spacer comprises dielectric material on sidewalls of the emitter and the collector and polysilicon material over the dielectric material.

14. The structure of one of claims 10 to 13, further comprising a base contact landing on the extrinsic base comprising polysilicon material, and, optionally, wherein the base contact is in a same active region of the collector and the emitter and is orthogonally positioned with respect to the collector and the emitter.

15. A method comprising:
forming an extrinsic base within a semiconductor material;
forming an emitter having a semiconductor material with a single crystalline orientation, the emitter being above the extrinsic base and comprising a faceted sidewall;
forming a collector having the semiconductor material with the single crystalline orientation, the collector being above the extrinsic base and comprising a faceted sidewall; and
forming a spacer between the emitter and the collector.
